# EUROPÄISCHE PATENTANMELDUNG

(11) **EP 3 477 447 A1**
(43) Veröffentlichungstag der Anmeldung: **01.05.2019**
(21) Anmeldenummer: 18000821.1
(22) Anmeldetag: 22.10.2018
(51) Int. Cl.: G06F 3/044, H03K 17/96

(54) **BERÜHRUNGSTASTE MIT EINEM ANZEIGEBILDSCHIRM UND HAUSHALTSGERÄT**

(30) Priorität: 26.10.2017 CN 201711010415
(71) Anmelder: Diehl AKO Stiftung & Co. KG, 88239 Wangen (DE)
(72) Erfinder: LI, Yan, Nanjing, CN - 210046 (CN)
(74) Vertreter: Diehl Patentabteilung

(57) **Zusammenfassung**

Die vorliegende Erfindung betrifft eine Berührungstaste (1, 2, 3) mit einem Anzeigebildschirm (12, 22, 32), die ein Bedienfeld (11, 21, 31), einen Berührungssensor (13, 23, 33), einen Anzeigebildschirm (12, 22, 32) und eine Leiterplatte (14, 24, 34) aufweist, wobei der Berührungssensor eine Berührungsbetätigung auf dem Bedienfeld erfassen kann, wobei der Berührungssensor (13, 23, 33) und der Anzeigebildschirm (12, 22, 32) jeweils mit der Leiterplatte (14, 24, 34) elektrisch verbunden sind, und wobei der Anzeigebildschirm (12, 22, 23) verschiedene Tastenfunktionen und/oder verschiedene Zustände anzeigen kann, die mit einer Betätigung der Berührungstaste im Zusammenhang stehen. Ferner betrifft die vorliegende Erfindung ein Haushaltsgerät.

## Beschreibung

### Technisches Gebiet

Die vorliegende Erfindung betrifft eine Berührungstaste mit einem Anzeigebildschirm. Die vorliegende Erfindung betrifft ferner ein Haushaltsgerät, das eine erfindungsgemäße Berührungstaste aufweist.

### Stand der Technik

Im Stand der Technik weist eine Taste eines Haushaltsgeräts üblicherweise Zeichen zum Hinweisen auf Tastenfunktionen oder Symbole auf, die mit Lampen beleuchtet und erloschen werden können. Diese Zeichen und Symbole sind unveränderbar. Somit kann jede Taste nur einer eingeschränkten Funktion entsprechen. Um verschiedene Funktionen zu ermöglichen, muss eine Vielzahl von Tasten auf dem Bedienfeld des Haushaltsgeräts vorgesehen werden. Dies ist für die intuitive Betätigung des Benutzers und das einfache Aussehen des Bedienfelds des Haushaltsgeräts nicht förderlich.

Aus Sicherheitsgründen haben einige Haushaltsgeräte auch eine Sperrfunktion, insbesondere eine Kindersicherungsfunktion. Um die Sperrfunktion zu aktivieren, ist es im Allgemeinen erforderlich, dass der Benutzer eine Vielzahl von Tasten gleichzeitig für eine lange Zeit drückt und hält. Dies erschwert die Benutzeraktionen.

Aus dem Stand der Technik ist eine Tastatur mit Anzeigefunktion zum Anzeigen der Tastenbezeichnungen bekannt, wobei ein elektronischer Anzeigebildschirm die Bezeichnungen anzeigen kann, die den Tasten jeweils entsprechen. Wenn eine Bezeichnung einer Taste, die auf dem elektronischen Anzeigebildschirm angezeigt ist, geändert werden muss, ist aber ein kompliziertes erneutes Einstellen der Leiterplatte erforderlich.

### Offenbarung der Erfindung

Dementsprechend liegt die Aufgabe der vorliegenden Erfindung darin, eine Berührungstaste bereitzustellen, die eine Vielzahl von Tastenfunktionen aufweist und einem Benutzer diese Funktionen und/oder einen Zustand zur Verfügung stellt, der mit der Betätigung der Taste im Zusammenhang steht.

Um die obige Aufgabe zu lösen, schlägt die vorliegende Erfindung eine Berührungstaste mit einem Anzeigebildschirm vor, die ein Bedienfeld, einen Berührungssensor, einen Anzeigebildschirm und eine Leiterplatte aufweist, wobei der Berührungssensor eine Berührungsbetätigung auf dem Bedienfeld erfassen kann, wobei der Berührungssensor und der Anzeigebildschirm jeweils mit der Leiterplatte elektrisch verbunden sind, wobei der Anzeigebildschirm verschiedene Tastenfunktionen und/oder verschiedene Zustände anzeigen kann, die mit einer Betätigung der Berührungstaste im Zusammenhang stehen.

Die vorliegende Erfindung stellt eine Berührungstaste bereit, die mit einem Anzeigebildschirm ausgestattet ist. Erfindungsgemäß wird die Größe der Berührungstaste im Allgemeinen auf eine Größe begrenzt, die einem oder mehreren Fingerabdruckteilen entspricht, um an die Berührungsbedienung eines Fingers eines Benutzers anzupassen. Die Größe der Berührungstaste ist nicht größer als 10 cm × 3 cm, vorzugsweise nicht größer als 7 cm × 2 cm, insbesondere 5 cm × 2 cm, 3 cm × 3 cm oder 2 cm × 2 cm. Der Anzeigebildschirm ist in der Mitte der Taste angeordnet, um den vordefinierten Anzeigeinhalt anzuzeigen. Der Anzeigebildschirm kann ein LCD-Anzeigebildschirm, ein Plasma-Anzeigebildschirm oder ein LED-Anzeigebildschirm sein, insbesondere ein OLED-Anzeigebildschirm. Durch den in der Berührungstaste angeordneten Anzeigebildschirm können die Tastenfunktionen vielfältig definiert oder zusätzliche Informationen angezeigt werden.

Der Anzeigebildschirm kann verschiedene Tastenfunktionen und/oder verschiedene Zustände anzeigen, die mit einer Betätigung der Berührungstaste im Zusammenhang stehen. Dadurch kann einerseits eine multifunktionale Berührungstaste bereitgestellt werden. Andererseits kann abhängig von den verschiedenen Funktionen der Berührungstaste der Benutzer auf diese Funktionen und/oder die entsprechenden Zustände hingewiesen werden, die mit der Betätigung der Berührungstaste im Zusammenhang stehen. Dadurch werden nicht nur die Tastenfunktionen integriert, sondern dem Benutzer können auch mehr Hinweise auf die Funktionen bzw. Zustände als im Stand der Technik bereitgestellt werden, so dass der Benutzer die aktuelle Funktion der Taste und/oder den aktuellen Zustand, der mit der Betätigung der Berührungstaste im Zusammenhang steht, verstehen kann, womit der Benutzer gezielter agieren kann.

Die Tastenfunktion kann die folgenden Funktionen umfassen: z.B. Öffnen, Schließen, Einschalten, Abschließen, Starten, Aussetzen, Anhalten, Sperren, Entsperren, Aufsteigen, Absenken und dergleichen. Die Zustände, die mit der Betätigung der Berührungstasten im Zusammenhang stehen, können folgende umfassen: "Starting" oder "Running" basierend auf einem Startvorgang, "Closed" oder "Finish Running" basierend auf einem Schließvorgang, "Paused" basierend auf einem Aussetzvorgang, "Gestoppt" basierend auf einem Stoppvorgang, "Gesperrt" basierend auf einem Sperrvorgang, "Entsperrt" basierend auf einem Entsperrvorgang und andere übliche Zustände. Natürlich sind die Tastenfunktionen und -zustände nicht auf die oben aufgeführten Beispiele beschränkt, sondern können sich auch auf andere Tastenfunktionen oder -zustände beziehen.

Die Berührungstaste hat ein Bedienfeld auf der oberen Seite. Das Bedienfeld kann transparent bzw. transluzent ausgebildet werden, so dass der Benutzer den Anzeigeinhalt des Anzeigebildschirms durch das Bedienfeld sieht. Das Material des Bedienfelds kann Glas, Plexiglas, transparente Keramik, transparentes Laminat oder dergleichen sein. Dabei ist die dem Benutzer zugewandte Seite als die Vorderseite des Bedienfelds definiert.

Die Berührungstaste umfasst einen Berührungssensor. Der Berührungssensor kann die Berührungsbetätigung des Bedienfelds erfassen. Mit anderen Worte kann der Berührungssensor die Berührung des Fingers des Benutzers auf dem Bedienfeld erfassen. Dabei ist die Anzahl von Berührungssensoren nicht auf einen beschränkt, sondern mehrere Berührungssensoren können nach Bedarf vorgesehen werden. Bei dem Berührungssensor kann es sich um einen kapazitiven Berührungssensor, einen resistiven Berührungssensor oder einen optischen Berührungssensor handeln. Der Berührungssensor kann auf einer vom Benutzer abgewandten Seite des Bedienfelds, auf dem Anzeigebildschirm oder auf der Leiterplatte angeordnet sein. Vorzugsweise kann der Berührungssensor an der dem Benutzer abgewandten Seite des Bedienfelds angeordnet, an den Anzeigebildschirm angelegt oder auf einer Leiterplatte aufgelegt oder einfach auf der Leiterplatte gebildet sein.

Die Berührungstaste umfasst ferner eine Leiterplatte. Dabei kann die Leiterplatte dem Anzeigebildschirm ein Anzeigesignal bereitstellen und Signale empfangen, die durch den Berührungssensor eingegeben werden. Um diese Signale zu übertragen, sind der Berührungssensor und der Anzeigebildschirm elektrisch mit der Leiterplatte verbunden. Die Leiterplatte kann eine Antriebssoftware zum Speichern des Anzeigebildschirms und einen Speicher zum Anzeigen des Inhalts sowie einen Prozessor zum Verarbeiten von Signalen, die von dem Benutzer auf dem Berührungssensor eingegeben werden, aufweisen. Als programmierbare Hardware kann die Leiterplatte eine integrierte Schaltung, eine anwendungsspezifische integrierte Schaltung, ein System-on-Chip, ein programmierbares Logikelement oder ein feldprogrammierbares Gate-Array mit einem Mikroprozessor sein.

Gemäß einer Ausführungsform ist der Berührungssensor als ein Berührungsfilm ausgebildet, der vollständig oder teilweise zwischen dem Bedienfeld und dem Anzeigebildschirm angeordnet ist. Einerseits kann der Berührungsfilm auf der Rückseite des Bedienfelds angeordnet sein. Andererseits kann der Berührungsfilm auch auf dem Anzeigebildschirm angeordnet sein. Dadurch kann die Berührungsbedienung des Benutzers auf der Berührungstaste durch den Berührungsfilm kapazitiv erfasst werden.

Gemäß einer bevorzugten Ausführungsform ist der Anzeigebildschirm als ein OLED-Anzeigebildschirm ausgebildet. Der OLED-Anzeigebildschirm weist die Vorteile der geringen Dicke, der Energieeinsparung, der Selbstleuchtkraft und langer Lebensdauer auf. Diese Vorteile sind besonders vorteilhaft für die vorliegende Berührungstaste.

Gemäß einer Ausführungsform ist der Berührungssensor als eine Berührungsfeder ausgebildet, die um den Anzeigebildschirm herum zwischen dem Bedienfeld und der Leiterplatte abgestützt wird. Dadurch kann die Berührungsbedienung des Benutzers auf der Berührungstaste durch die Berührungsfeder kapazitiv erfasst werden.

Gemäß einer besonders bevorzugten Ausführungsform ist der Berührungssensor als eine Metallfolienschicht, insbesondere eine Kupferfolienschicht, auf der Leiterplatte ausgebildet. Dabei kann die Metallfolienschicht, insbesondere die Kupferfolienschicht, selbst auf der Leiterplatte ausgebildet oder aufgelegt werden. Dadurch kann insbesondere auf den Berührungsfilm und die Berührungsfeder in der obigen Ausführungsform verzichtet werden. So kann einerseits die Dicke der Berührungstaste verringert werden, andererseits kann durch Sparen der Komponente der Zweck der Kostenreduzierung erreicht werden. Bei dieser Ausführungsform ist besonders vorteilhaft, wenn die Metallfolienschicht, insbesondere die Kupferfolienschicht, als Induktionselektrode nahe dem Bedienfeld angeordnet ist. Vorzugsweise ist die Metallfolienschicht zur Verbesserung der Berührungsempfindlichkeit luftspaltfrei an dem Bedienfeld angelegt.

Die Leiterplatte kann mit einer oder mehreren Öffnungen versehen sein, in die der Anzeigebildschirm eingebettet ist, wobei die Metallfolienschicht um die Öffnung der Leiterplatte herum angeordnet ist. Der Anzeigebildschirm ist auf dem Gehäuse abgestützt oder mechanisch mit der Leiterplatte verbunden, beispielsweise durch eine feste Verbindung wie Einrasten, Kleben, Schweißen, Nieten oder dergleichen. Die Dicke der Berührungstaste wird durch eine solche Anordnung weiter verringert.

Gemäß einer zweiten Ausführungsform umfasst die Berührungstaste ein Gehäuse, in dem der Berührungssensor, der Anzeigebildschirm und die Leiterplatte aufgenommen sind. Das Gehäuse kann als ein hohler Würfel mit einer offenen Seite, ein hohler Kreiszylinder mit einem geschlossenen Ende oder eine andere hohle Geometrie ausgebildet sein. Das Gehäuse kann mit dem Bedienfeld verbunden sein, beispielsweise durch Trockenverbinden, Crimpen, Einrasten, Schweißen oder dergleichen. Vorzugsweise sind das Bedienfeld und das Gehäuse geschlossen ausgebildet, um eine bessere Dichtheit der Berührungstaste zu erzielen, wodurch die Effekte der Feuchtigkeitsbeständigkeit, der Wasserdichtheit, der Öldichtheit und der Verhinderung des Leckstroms erreicht sind.

Gemäß einer anderen Ausführungsform ist ein Anzeigeinhalt des Anzeigebildschirms als Antwort auf die Betätigung der Berührungstaste veränderbar. Dadurch können mehr als eine, bevorzugt zwei, bevorzugter drei oder mehr als drei Tastenfunktionen mit einer Berührungstaste realisiert werden. Daher kann im Vergleich zu der einzigen Tastenfunktion im Stand der Technik die Multifunktionalität der Berührungstaste realisiert werden, so dass die Funktionsdefinition der Berührungstaste komplex ist. Ferner kann die Betätigung der Berührungstaste nicht nur als Eingabe für die Berührungstaste dienen, sondern auch andere Funktionen oder Zustände derselben Taste auslösen. Dies führt zu einer operationsbasierten Informationsverfolgung, die dem Benutzer ein einzigartiges Eingabeerlebnis gibt, sodass er beim Betätigen die Intelligenz der Berührungstaste spürt. Die Berührungstaste ist insbesondere beim Haushaltsgerät verwendbar. Das Haushaltsgerät kann die Berührungstaste umfassen, wobei die Berührungstaste mit einem Steuergerät oder einem Prozessor des Haushaltsgeräts verbindbar ist, um ein auf der Berührungstaste eingegebenes Betätigungssignal an das Haushaltsgerät zu übertragen. Diese Ausführungsform bewirkt besonders vorteilhafte Vorteile, wenn die Berührungstaste beim Haushaltsgerät verwendet ist: Die multifunktionale Berührungstaste vereinfacht das Layout des Bedienfelds und reduziert die Anzahl der Betätigungsknöpfe/-tasten, sodass das Bedienfeld schöner und einfacher wird. Dadurch ist ferner die Anzahl der Komponenten des Haushaltsgeräts reduzierbar und somit sind die Herstellungs- und Wartungskosten des Haushaltsgeräts reduzierbar.

Gemäß einer Ausführungsform kann der Berührungssensor eine Berührung, ein langzeitiges Drücken, ein Doppelklicken und ein Schieben erfassen. Die Berührungstasten werden durch verschiedene Arten einer Berührung betätigt. Dies ermöglicht, dass verschiedene Betätigungen mit einer Taste ausgeführt werden können. Besonders vorteilhaft ist, dass der Benutzer abhängig von den vielfältigen Hinweisen auf dem Anzeigebildschirm die Berührungstaste auf verschiedene Weisen betätigen kann. Dabei kann das "Schieben" auf der Berührungstaste als eine Sperrfunktion und/oder eine Entsperrfunktion definiert werden, um beispielsweise das Sperren und/oder Entsperren zu vermeiden, das von einem Kind bewirkt oder durch eine unabsichtliche Fehlbedienung verursacht wird, wodurch die Sicherheit des mit der Berührungstaste verbundenen Haushaltsgeräts sichergestellt wird. Im Vergleich mit dem gleichzeitigen langzeitigen Drücken einiger Tasten im Stand der Technik kann die Berührungstaste auf eine deutlich einfachere Weise das Aktivieren bzw. Deaktivieren der Sperrung realisieren, so dass die Betätigung des Benutzers vereinfacht wird.

Gemäß einer Ausführungsform ist die Berührungstaste als Rechteck,Quadrat, Kreis, Ellipse, Dreieck oder in einer unregelmäßigen Form ausgebildet.

Es wird ferner ein Haushaltsgerät vorgeschlagen, das eine solche Berührungstaste aufweist. Insbesondere ist die Berührungstaste mit einem Steuergerät oder einem Prozessor des Haushaltsgeräts verbindbar, um ein auf der Berührungstaste eingegebenes Betätigungssignal an das Haushaltsgerät zu übertragen und/oder das Feedback über die Eingabe und/oder die Information über den Zustand vom Haushaltsgerät zu empfangen. Das Haushaltsgerät kann eine Waschmaschine, ein Kühlschrank, ein Mikrowellenofen, ein Gasherd, eine Dunstabzugshaube, ein Fernsehgerät, eine Klimaanlage, ein Trockner, ein Luftfilter oder dergleichen sein.

Gemäß einer Ausführungsform kann der Anzeigebildschirm der Berührungstaste zusätzlich den Zustand des Haushaltsgeräts anzeigen. Durch diese Ausführungsform wird die Funktion der Berührungstaste umfangreicher. Die Berührungstaste kann nicht nur den Benutzer auf die verschiedenen Tastenfunktionen und/oder verschiedenen Zustände, die mit der Betätigung der Berührungstaste im Zusammenhang stehen, hinweisen, sondern auch den Betriebszustand bzw. die allgemeinen Informationen des mit der Berührungstaste verbundenen Haushaltsgeräts anzeigen. Somit kann die Tastenfunktion komplexer definiert werden als im Stand der Technik.

Gemäß einer Ausführungsform ist der Anzeigeinhalt der Berührungstaste als Reaktion auf eine Benutzerbetätigung und/oder eine Zustandsänderung des Haushaltsgeräts verändert. Durch diese Ausführungsform wird eine Informationsverfolgung des Anzeigeinhalts ermöglicht, die insbesondere auf einer Betätigung oder einer Zustandsänderung des Haushaltsgeräts basiert, wodurch dem Benutzer ein einzigartiges Eingabeerlebnis bereitgestellt wird, sodass er beim Betätigen die Intelligenz der Berührungstaste spürt.

### Kurze Beschreibung der Figuren

Fig. 1a zeigt eine Vorderansicht einer Berührungstaste gemäß einer ersten Ausführungsform;
Fig. 1b zeigt eine Schnittansicht einer Berührungstaste gemäß der ersten Ausführungsform;
Fig. 2a zeigt eine Vorderansicht einer Berührungstaste gemäß einer zweiten Ausführungsform;
Fig. 2b zeigt eine Schnittansicht einer Berührungstaste gemäß der zweiten Ausführungsform;
Fig. 3a zeigt eine Vorderansicht einer Berührungstaste gemäß einer dritten Ausführungsform;
Fig. 3b zeigt eine Schnittansicht einer Berührungstaste gemäß der dritten Ausführungsform;
Fig. 4a zeigt einen anfänglichen Anzeigeinhalt einer Berührungstaste gemäß einer Ausführungsform;
Fig. 4b zeigt einen Anzeigeinhalt einer Berührungstaste nach einmaliger Berührung gemäß einer Ausführungsform;
Fig. 4c zeigt einen Anzeigeinhalt einer Berührungstaste nach einer weiteren Berührung gemäß einer Ausführungsform;
Fig. 5a zeigt einen Anzeigeinhalt, wenn die Berührungstaste gemäß einer Ausführungsform auf die Kindersicherungsfunktion hinweist;
Fig. 5b zeigt einen Anzeigeinhalt, wenn die Berührungstaste gemäß einer Ausführungsform auf das Entsperren hinweist;
Fig. 6 zeigt eine Waschmaschine mit einer Berührungstaste; und
Fig. 7 zeigt einen Anzeigeinhalt, der üblich ist, wenn die Berührungstaste bei einer Waschmaschine angewendet wird.

### Ausführliche Ausführungsformen

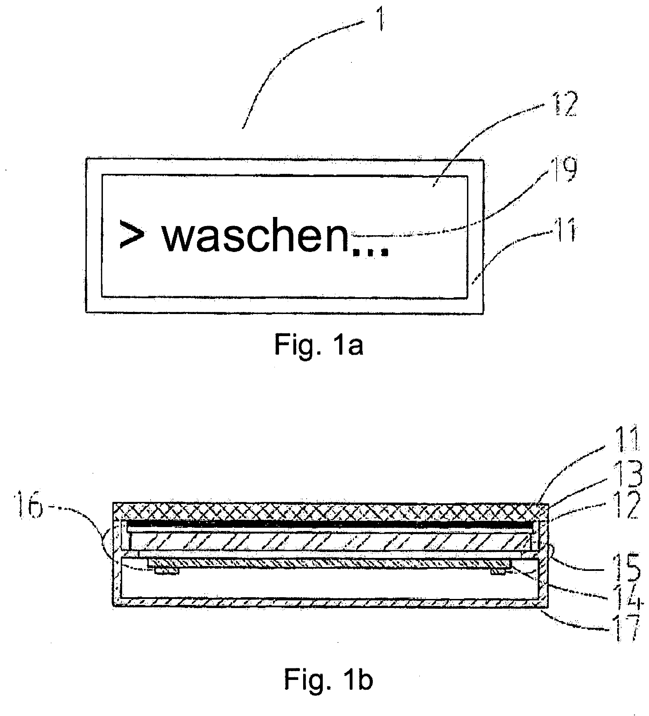

Fig. 1a zeigt eine Vorderansicht einer Berührungstaste gemäß einer ersten Ausführungsform. Wie in der Figur gezeigt, umfasst die Berührungstaste 1 ein Bedienfeld 11 und einen Anzeigebildschirm 12. Dabei sind das Bedienfeld 11 und der Anzeigebildschirm 12 rechteckig ausgebildet. Der Anzeigebildschirm 12 vorzugsweise als ein OLED-Anzeigebildschirm ausgebildet. Der Anzeigebildschirm kann verschiedene Tastenfunktionen und/oder verschiedene Zustände anzeigen, die mit einer Betätigung der Berührungstaste im Zusammenhang stehen. Bei einer Kombination der Berührungstaste mit dem Haushaltsgerät kann die Berührungstaste zusätzlich den Zustand des Haushaltsgeräts anzeigen. In der Fig. 1a ist die Berührungstaste 1 für die Waschmaschine gezeigt. Auf dem Anzeigebildschirm 12 ist der Anzeigeinhalt 19 ersichtlich: ">waschen..." gibt in der Anwendung der Waschmaschine normalerweise allgemein an, dass sich die Waschmaschine in einem Waschvorgang befindet. Der Anzeigebildschirm kann verschiedene Tastenfunktionen und/oder verschiedene, mit der Betätigung der Berührungstaste im Zusammenhang stehende Zustände anzeigen. Insbesondere ist ein Anzeigeinhalt des Anzeigebildschirms 12 als Reaktion auf eine Betätigung eines Benutzers und/oder eine Zustandsänderung des Haushaltsgeräts veränderbar.

Fig. 1b zeigt eine Schnittansicht einer Berührungstaste gemäß der ersten Ausführungsform. Die Berührungstaste 1 umfasst ein Bedienfeld 11, einen Berührungssensor 13, einen unter dem Berührungssensor angeordneten Anzeigebildschirm 12, eine Leiterplatte 14 und ein Gehäuse 17. Dabei kann der Berührungssensor die Berührungsbetätigung des Bedienfelds erfassen. In der gezeigten Ausführungsform sind im Gehäuse 17 der Berührungssensor 13, der Anzeigebildschirm 12 und die Leiterplatte 14 aufgenommen, wobei der Berührungssensor 13 über ein Berührungssensorkabel 16 mit der Leiterplatte 14 elektrisch verbunden ist, wobei der Anzeigebildschirm 12 über ein Anzeigebildschirmkabel 15 mit der Leiterplatte 14 elektrisch verbunden ist.

In Fig. 1b ist das Bedienfeld 11 am obersten dargestellt. Wenn der Benutzer die Berührungstaste betätigt, führt er die Betätigung direkt auf dem Bedienfeld durch. Das Bedienfeld kann transparent bzw. transluzent ausgebildet werden, so dass der Benutzer den Anzeigeinhalt des Anzeigebildschirms durch das Bedienfeld sieht. Das Material des Bedienfelds kann Glas, Plexiglas, transparente Keramik, transparentes Laminat oder dergleichen sein. Dabei ist die dem Benutzer zugewandte Seite als die Vorderseite des Bedienfelds definiert.

Gemäß der vertikalen Richtung des Zeichnungsblatts von Fig. 1b ist ein Berührungssensor 13 unter dem Bedienfeld 11 (d.h., auf der Rückseite des Bedienfelds 11) angeordnet. Der Berührungssensor kann die Berührungsbetätigung des Bedienfelds erfassen. Mit anderen Worten dient der Berührungssensor dem Erfassen der Berührung des Fingers des Benutzers auf dem Bedienfeld. Bei dem Berührungssensor kann es sich um einen kapazitiven Berührungssensor, einen resistiven Berührungssensor oder einen optischen Berührungssensor handeln. In der ersten Ausführungsform ist der Berührungssensor 13 als ein Berührungsfilm ausgebildet, der einen Finger auf dem Bedienfeld erfassen kann. Dabei ist der Berührungsfilm zwischen dem Bedienfeld 11 und dem Anzeigebildschirm 12 angeordnet, wobei der Berührungsfilm die Rückseite des Bedienfelds bilden, insbesondere an der Rückseite des Bedienfelds anliegen, kann. Dies ist jedoch nicht auf die gezeigten Ausführungsformen beschränkt, und der Berührungsfilm kann auch den Anzeigebildschirm bilden, insbesondere an dem Anzeigebildschirm anliegen. Damit der Benutzer den Anzeigeinhalt des Anzeigebildschirms sehen kann, muss der Berührungsfilm transparent bzw. transluzent ausgebildet werden. Wenn der Benutzer das Bedienfeld berührt, d.h. den Berührungsfilm betätigt, kann der Berührungsfilm ein elektrisches Signal erzeugen, wobei das entsprechende elektrische Signal über das Berührungssensorkabel 16 an die Leiterplatte 14 übertragen werden kann, wodurch eine Eingabe an die Berührungstaste 1 ermöglicht wird. In der hier gezeigten Ausführungsform ist der Berührungsfilm mit seiner gesamten Fläche über dem Anzeigebildschirm 12 angeordnet. Wahlweise kann nur auf einem Teilbereich des Anzeigebildschirms 12 der Berührungsfilm angeordnet werden. Um eine bessere Berührungsempfindlichkeit zu erzielen, kann der Berührungsfilm luftspaltfrei an der Rückseite des Bedienfelds 11 anliegen.

Gemäß der vertikalen Richtung des Zeichnungsblatts von Fig. 1b ist ein Anzeigebildschirm 12 unter dem Berührungsfilm angeordnet. Der Anzeigebildschirm 12 kann ein LCD-Anzeigebildschirm, ein Plasma-Anzeigebildschirm oder ein LED-Anzeigebildschirm sein, insbesondere ein OLED-Anzeigebildschirm. Durch den Anzeigebildschirm können die Tastenfunktionen vielfältig definiert oder zusätzliche Informationen angezeigt werden. Vorzugsweise wird ein OLED-Anzeigebildschirm verwendet, der die Vorteile der geringen Dicke, der Energieeinsparung, der Selbstleuchtkraft und langer Lebensdauer usw. aufweist. Diese Vorteile sind besonders vorteilhaft für die vorgeschlagene Berührungstaste.

Gemäß der vertikalen Richtung des Zeichnungsblatts von Fig. 1b ist eine Leiterplatte 14 unter dem Anzeigebildschirm angeordnet. Die Leiterplatte 14 kann einerseits dem Anzeigebildschirm 12 Anzeigesignale bereitstellen und andererseits Signale empfangen, die durch den Berührungssensor 13 eingegeben werden. Um diese Signale zu übertragen, ist der Berührungssensor 13 über das Berührungssensorkabel 16 mit der Leiterplatte 14 und der Anzeigebildschirm 12 über das Anzeigebildschirmkabel 15 mit der Leiterplatte 14 elektrisch verbunden. Die Leiterplatte 14 kann eine Antriebssoftware zum Speichern des Anzeigebildschirms und einen Speicher zum Anzeigen des Inhalts sowie einen Prozessor zum Verarbeiten von Signalen, die von dem Benutzer auf dem Berührungssensor eingegeben werden, aufweisen. Als programmierbare Hardware kann die Leiterplatte 14 eine integrierte Schaltung, eine anwendungsspezifische integrierte Schaltung, ein System-on-Chip, ein programmierbares Logikelement oder ein feldprogrammierbares Gate-Array mit einem Mikroprozessor sein.

Die Berührungstaste 1 in der Fig. 1b weist ferner ein Gehäuse 17 auf. Dabei ist das Gehäuse 17 ein hohler Würfel mit einer offenen Seite oder ein hoher viereckiger Kasten. Das Gehäuse 17 und das Bedienfeld 11 bilden einen vorzugsweise geschlossenen Hohlraum zum Aufnehmen des Berührungssensors 13, des unter dem Berührungssensor angeordneten Anzeigebildschirms 12, der Leiterplatte 14, des Berührungssensorkabels 16 und des Anzeigebildschirmkabels 15. Wie in Fig. 1b gezeigt, weist das Gehäuse 17 Seitenwände und eine Bodenwand auf. An Mittelteilen der Seitenwände sind gegenüberliegende bzw. umlaufende Vorsprünge vorgesehen, die zum Abstützen und Befestigen des Anzeigebildschirms 12 ausgebildet sind. Zusätzlich kann das Gehäuse 17 auch die Leiterplatte abstützen und befestigen. Das Gehäuse kann mit dem Bedienfeld verbunden sein, beispielsweise durch Kleben, Crimpen, Einrasten, Schweißen oder dergleichen. Vorzugsweise sind das Bedienfeld und das Gehäuse geschlossen ausgebildet, um eine bessere Dichtheit der Berührungstaste zu erzielen, wodurch die Effekte der Feuchtigkeitsbeständigkeit, der Wasserdichtheit, der Öldichtheit und der Verhinderung des Leckstroms erreicht sind.

Der Anzeigebildschirm 12 kann verschiedene Tastenfunktionen und/oder verschiedene Zustände anzeigen, die mit einer Betätigung der Berührungstaste in Zusammenhang stehen. Hier wird die Anwendung der Berührungstaste 1 in einer Waschmaschine als Haushaltsgerät als Beispiel genannt, um. den Betriebsmodus der Berührungstaste 1 vorzustellen. Es versteht sich, dass die Berührungstaste nicht auf die Anwendung bei Waschmaschinen beschränkt ist, sondern in breitem Umfang bei verschiedenen Haushaltsgeräten (z.B. Kühlschrank, Mikrowellenofen, Gasherd, Dunstabzugshaube, Fernsehgerät, Klimaanlage, Trockner, Luftfilter oder dergleichen) Anwendungen finden kann.

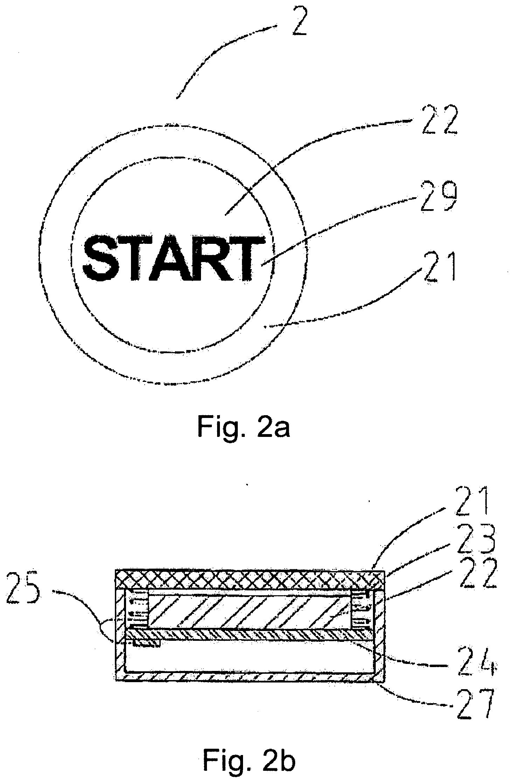

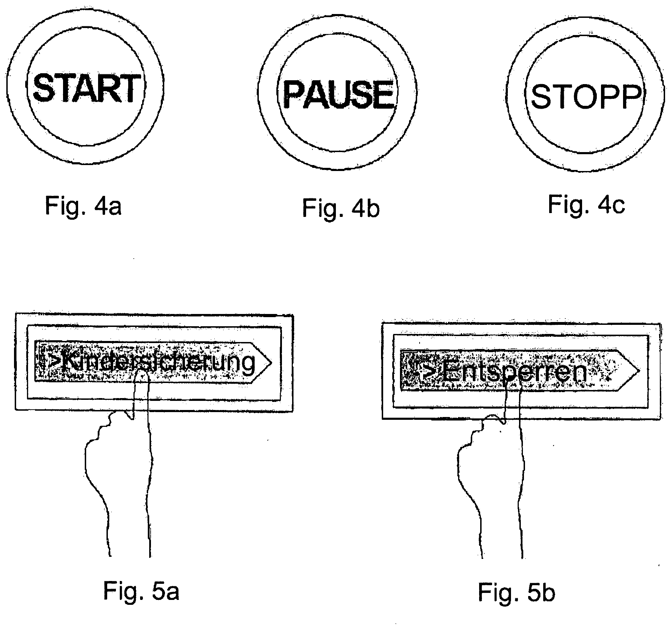

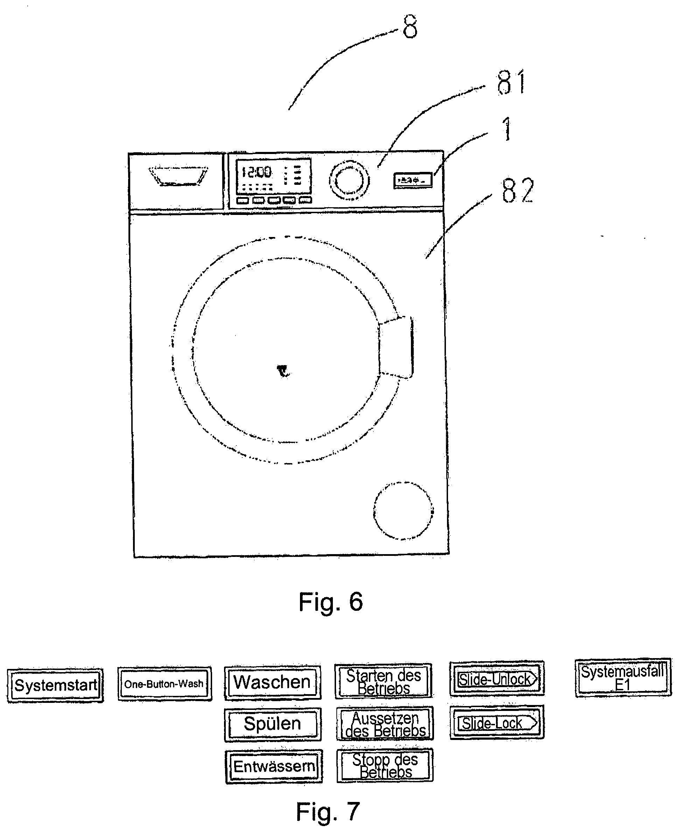

Dabei kann die Berührungstaste 1 als Eingabevorrichtung der Waschmaschine an der Bedienkonsole der Waschmaschine vorgesehen sein (siehe Fig. 6). Die Berührungstaste 1 kann durch die Stromversorgung der Waschmaschine mit Strom versorgt werden und empfängt Signale von der Waschmaschine. Dazu kann die Leiterplatte 14 der Berührungstaste 1 mit der Waschmaschine, insbesondere mit deren Steuergerät oder Prozessor elektrisch verbunden werden. Wenn die Waschmaschine eingeschaltet ist, kann der Strom der Berührungstaste 1 zugeführt und ein Standby-Signal bereitgestellt werden. Dementsprechend überträgt die Leiterplatte 14 der Berührungstaste 1 über das Anzeigebildschirmkabel 15 ein Signal an den Anzeigebildschirm 12, um dem Benutzer den Anzeigeinhalt, z.B. "Loslaufen" oder "START", bereitzustellen. Wenn der Benutzer solchen Anzeigeinhalt sieht, ist er sich bewusst, dass die aktuelle Tastenfunktion der Berührungstaste 1 darin besteht, die Waschmaschine zu starten. Wenn der Benutzer zu diesem Zeitpunkt das Bedienfeld 11 der Berührungstaste 1 berührt, erzeugt der Berührungssensor 13 ein induktives Signal, das über das Berührungssensorkabel 16 an die Leiterplatte 14 übertragen wird. Somit bestimmt die Leiterplatte 14, dass der Benutzer einen Eingabevorgang "Loslaufen" durch die Berührungstaste 1 ausführt und diesen Befehl an das Steuergerät oder den Prozessor der Waschmaschine aussendet. Die Waschmaschine startet aufgrund eines Befehls, der dem Eingabevorgang der Berührungstaste 1 entspricht, ihren Betrieb. Nach dem Start des Betriebs kann die Waschmaschine optional das Ausführungsergebnis des obigen Befehls an die Berührungstaste 1 zurückgeben, beispielsweise ein Signal an die Berührungstaste 1 aussenden, um anzudeuten, dass die Waschmaschine im Betrieb ist und sich im Waschvorgang befindet. Nachdem die Berührungstaste 1 das Signal empfangen hat, kann der Anzeigebildschirm 12 durch das Anzeigebildschirmkabel 15 den Anzeigebildschirm anweisen, dessen Anzeigeinhalt in den Anzeigeinhalt ">waschen...", wie in Fig. 1a gezeigt, zu ändern, wodurch dem Benutzer angezeigt wird, dass sich die Waschmaschine im Waschvorgang befindet. Nicht darauf beschränkt, kann die Berührungstaste 1 auch autonom oder in Kooperation mit der Waschmaschine den Anzeigeinhalt in "PAUSE" ändern, wobei "PAUSE" ein Aussetzen des Betriebs darstellt, wie in Fig. 4b gezeigt. Fig. 2a zeigt eine Vorderansicht einer Berührungstaste gemäß einer zweiten Ausführungsform. Anders als die rechteckige Ausbildung in der ersten Ausführungsform ist hier eine kreisförmige Berührungstaste 2 gezeigt. Dazu sind das Bedienfeld 21 und der Anzeigebildschirm 22 kreisförmig ausgebildet. Nicht auf die Beispiele der Fig. 1a und 2a beschränkt, ist die Berührungstaste auch als Ellipse, Dreieck oder in einer unregelmäßigen Form usw. ausgebildet. Auf dem Anzeigebildschirm 22 ist der Anzeigeinhalt 29 ersichtlich: "START" gibt in der Anwendung des Haushaltsgeräts normalerweise allgemein an, dass der Betrieb beginnt.

Gemäß der Schnittansicht der Berührungstaste gemäß dem zweiten Ausführungsbeispiel in Fig. 2b weist, ähnlich wie der Fall in dem ersten Ausführungsbeispiel, die Berührungstaste 2 ebenfalls ein Bedienfeld 21, einen Anzeigebildschirm 22, eine Leiterplatte 24 und ein Gehäuse 27 auf, wobei der Anzeigebildschirm 22 über ein Anzeigebildschirmkabel 25 mit der Leiterplatte 24 verbunden ist. Entsprechend ist das Gehäuse 27 als ein hohler Kreiszylinder mit einem geschlossenen Ende ausgebildet. Die Leiterplatte 24 ist an Seitenwänden des Gehäuses 27 befestigt. Auf der Leiterplatte 24 ist ein Anzeigebildschirm 22 abgestützt. Dabei ist denkbar, dass der Anzeigebildschirm 22 mechanisch mit der Leiterplatte 24 verbunden ist, beispielsweise durch eine feste Verbindung wie Einrasten, Kleben, Schweißen, Nieten oder dergleichen. Für die oben erwähnten Vorrichtungen und ihre Arbeitsprinzipien kann auf die Beschreibung der Fig. 1a und 1b Bezug genommen werden.

Signifikant anders als bei der ersten Ausführungsform ist, dass der Berührungssensor 23 in Fig. 2b, der die Berührungsbetätigung des Bedienfelds erfassen kann, anstelle als ein Berührungsfilm als eine Berührungsfeder 11 ausgebildet ist, wobei die Berührungsfeder um den Anzeigebildschirm 22 herum zwischen dem Bedienfeld 21 und der Leiterplatte 24 abgestützt ist. Ferner ist die Berührungsfeder direkt mit der Leiterplatte 24 elektrisch verbunden. Bei der Berührungsfeder hier handelt es sich um einen mit Federn gebildeten kapazitiven Sensor, der ebenfalls als ein Berührungsempfänger die menschliche Berührung erfasst und beim Berühren ein elektrisches Signal erzeugt. Wenn der Benutzer das Bedienfeld berührt, d.h. die Berührungsfeder betätigt, kann die Berührungsfeder ein elektrisches Signal erzeugen, wobei das entsprechende elektrische Signal direkt an die Leiterplatte 24 übertragen werden kann. Dadurch wird die Eingabe der Berührungstaste 2 ermöglicht.

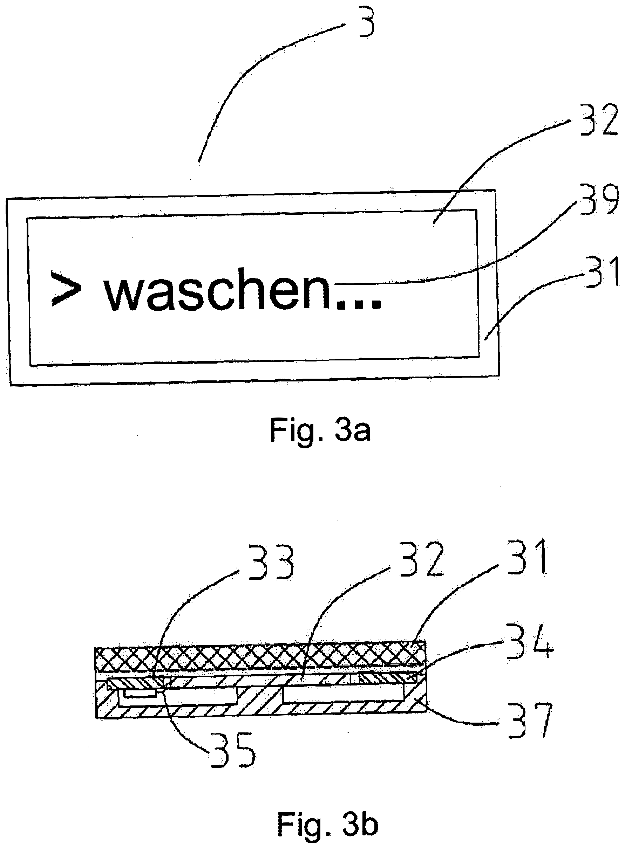

Fig. 3a zeigt eine Vorderansicht einer Berührungstaste gemäß einer dritten Ausführungsform. Wie aus der Figur ersichtlich ist, stimmt die dritte Ausführungsform der Berührungstaste mit der in Fig. 1a gezeigten Berührungstaste 1 in der Vorderansicht überein. Die Berührungstaste 3 umfasst ein Bedienfeld 31 und einen rechteckigen Anzeigebildschirm 32. Auf dem Anzeigebildschirm 32 ist auch der Anzeigeinhalt 39 ersichtlich: ">waschen...".

Fig. 3b zeigt eine Schnittansicht einer Berührungstaste gemäß der dritten Ausführungsform. In einem aus dem Bedienfeld 31 und dem Gehäuse 37 bestehenden Hohlraum sind auch ein Anzeigebildschirm 32 und eine Leiterplatte 34 angeordnet. Wie in der Figur gezeigt, weist das Gehäuse 37 Seitenwände und eine Bodenwand auf. An den Seitenwänden des Gehäuses 37 sind gegenüberliegende bzw. umlaufende Vorsprünge vorgesehen, um die Leiterplatte 34 abzustützen. Dabei umfasst die Leiterplatte 34 eine Öffnung, insbesondere eine rechteckige Öffnung, in die der Anzeigebildschirm 32 eingebettet ist. Dabei hat der Anzeigebildschirm 34 eine Form und Größe, die jeweils an die Form und Größe der Öffnung der Leiterplatte angepasst sind. Der Anzeigebildschirm 32 ist mit der Leiterplatte 34 über ein Anzeigebildschirmkabel 35 elektrisch verbunden. In der gezeigten Figur ist an der Bodenwand des Gehäuses 37 noch ein Vorsprung angeordnet, wobei sich der Anzeigebildschirm 32 zusätzlich an dem Vorsprung des Gehäuses 37 abstützt. Nicht darauf beschränkt, ist auch denkbar, dass der Anzeigebildschirm 32 mechanisch mit der Leiterplatte 34 verbunden ist, beispielsweise durch eine feste Verbindung wie Einrasten, Kleben, Schweißen, Nieten oder dergleichen. Für die oben erwähnten Vorrichtungen und ihre Arbeitsprinzipien kann auf die Beschreibung der Fig. 1a und 1b Bezug genommen werden.

In diesem Ausführungsbeispiel ist der Berührungssensor 33, der die Berührungsbetätigung des Bedienfelds erfassen kann, als eine Metallfolienschicht, insbesondere eine Kupferfolienschicht, auf der Leiterplatte ausgebildet, wobei die Metallfolienschicht um die Öffnung der Leiterplatte 34 herum vorgesehen ist. Dadurch kann eine dünne Metallschicht, die üblicherweise auf der Leiterplatte vorgesehen ist, als Berührungssensor die menschliche Berührung kapazitiv erfassen. Wenn der Benutzer das Bedienfeld berührt, d.h. die Metallfolienschicht betätigt, kann die Berührungsfeder ein elektrisches Signal erzeugen, wobei das entsprechende elektrische Signal direkt an die Leiterplatte 34 übertragen werden kann. Um die Berührungsempfindlichkeit zu verbessern, liegt vorzugsweise die Metallfolienschicht möglichst luftspaltfrei an dem Bedienfeld an. Ferner muss angemerkt werden, dass die Anzahl der Öffnungen auf der Leiterplatte 34, der Berührungssensoren und der Anzeigebildschirme nicht auf eins beschränkt ist und mehrere sein und jede beliebige Form haben kann.

Fig. 4a, 4b und 4c zeigen jeweils einen anfänglichen Anzeigeinhalt einer Berührungstaste, einen Anzeigeinhalt der Berührungstaste nach einmaliger Berührung sowie einen Anzeigeinhalt einer Berührungstaste nach einer weiteren Berührung gemäß einer Ausführungsform der vorliegenden Erfindung. Am Anfang zeigt die Berührungstaste "START", was bedeutet, dass die Tastenfunktion mit dem Betrieb anfängt. Wenn der Benutzer zu diesem Zeitpunkt die Taste berührt, wird ein Befehl zum Starten des Betriebs an das Haushaltsgerät eingegeben, das mit der Taste verbunden ist. Dementsprechend startet das Haushaltsgerät den Betrieb. Nach dem Start des Betriebs zeigt die Berührungstaste "PAUSE" zum Darstellen des Aussetzens des Betriebs an. D.h., als Antwort auf diese Betätigung des Benutzers ist der Anzeigeinhalt der Berührungstaste in "PAUSE" geändert, während die Funktion der Berührungstaste in das Aussetzen des Betriebs geändert ist. Falls die Taste zu diesem Zeitpunkt berührt wird, wird das Haushaltsgerät ausgesetzt und der Anzeigeinhalt der Berührungstaste wiederum in "STOPP" zum Darstellen eines Stopps des Betriebs geändert. D.h., als Antwort auf diese Betätigung des Benutzers ist der Anzeigeinhalt der Berührungstaste in "STOPP" geändert, während die Funktion der Berührungstaste in den Stopp des Betriebs geändert ist. Falls die Taste zu diesem Zeitpunkt erneut berührt wird, hört das Haushaltsgerät mit dem Betrieb auf.

Aus den Figuren 4a, 4b und 4c ist ersichtlich, dass dieselbe Taste verschiedene Tastenzustände oder verschiedene Anzeigeinhalte für verschiedene Tastenfunktionen aufweist, wobei dieselbe Berührungstaste drei verschiedene Tastenfunktionen aufweist: Starten des Betriebs, Aussetzen des Betriebes und Stoppen des Betriebs. Einerseits realisiert dies im Vergleich zu der im Stand der Technik üblich vorhandenen Power-Taste oder Start/Stopp-Taste mit nur zwei Zuständen, und zwar Einschalten und Ausschalten, die Funktionsvielfalt auf derselben Taste, wodurch die Tastenfunktionen auf der Bedienkonsole bereichert sind und somit die Anzahl der Tasten reduzierbar ist, wobei das Layout der Bedienkonsole optimiert wird, so dass die Bedienkonsole einfacher und schöner wird. Andererseits ist der Anzeigeinhalt des Anzeigebildschirms als Antwort auf die Betätigung der Berührungstaste veränderbar. Die Betätigung der Berührungstaste kann nicht nur als Eingabe für die Berührungstaste dienen, sondern auch andere Funktionen oder Zustände derselben Taste auslösen, wodurch eine Informationsverfolgung realisiert wird.

Fig. 5a und Fig. 5b zeigen jeweils Anzeigeinhalte, wenn die Berührungstaste gemäß einer Ausführungsform auf die Kindersicherungsfunktion oder die Entsperrfunktion hinweist. Auf der Berührungstaste ist der Anzeigeinhalt (wie in Fig. 5a gezeigt) angezeigt: Bei ">CHILD LOCK" (Kindersicherung) ermöglicht das Schieben von links nach rechts auf der Berührungstaste durch eine Hand des Benutzers (schematisch in Fig. 5a gezeigt) das Sperren des Haushaltsgeräts, das mit der Berührungstaste verbunden ist, so dass die verschiedenen funktionalen Vorgänge des Haushaltsgeräts gesperrt sind, um eine Betätigung von einem Kind oder eine unabsichtliche Fehlbedienung zu vermeiden. Wahlweise kann die Berührungstaste nach dem Aktivieren der Kindersicherungsfunktion als Antwort auf den vorherigen Schiebevorgang ">UNLOCK" (Entsperren) in Fig. 5b anzeigen, um den Benutzer darauf hinzuweisen, dass durch ein Schieben von links nach rechts auf der Berührungstaste die vorher gesperrte Funktion entsperrt wird.

Ferner sind das Sperren und das Entsperren nicht auf die gezeigte Form beschränkt. Es ist auch denkbar, durch Anzeigen den Benutzer auf eine gewünschte Berührungsart (z.B., langzeitiges Drücken bzw. Doppelklicken) oder eine gewünschte Berührungsspur (z.B., eine sich von rechts nach links erstreckende Spur, eine gekrümmte, gewellte, gefaltete, übersprungene oder in der Mitte des Anzeigebildschirms angehaltene Spur) hinzuweisen, so dass der Benutzer eine entsprechende Berührung durchführt, um das Sperren oder das Entsperren zu ermöglichen.

Fig. 6 zeigt als ein Beispiel eines Haushaltsgeräts eine Waschmaschine 8, die mit einer Berührungstaste ausgestattet ist, wobei die Waschmaschine eine Bedienkonsole 81 und einen Waschmaschinenkörper 82 aufweist, wobei die Berührungstaste 1 an der Bedienkonsole 81 angebracht ist.

Fig. 7 zeigt einen Anzeigeinhalt, der üblich ist, wenn die Berührungstaste bei einer Waschmaschine angewendet wird. Insgesamt werden hier 11 verschiedene Anzeigeinhalte angezeigt. Dabei können "Systemstart", "Waschen", "Spülen", "Entwässern" und "Systemausfall E1" den Zustand des Haushaltsgeräts anzeigen, das mit der Berührungstaste verbunden ist. "One-Button-Wash", "Starten des Betriebs", "Aussetzen des "Betriebs", "Stopp des Betriebs", "Slide-Unlock" und "Slide-Lock" zeigen jeweils die Tastenfunktion der Berührungstaste in verschiedenen Situationen an. Nicht darauf beschränkt, kann die Berührungstaste noch die allgemeinen Informationen wie das Datum, die Zeit, die Temperatur, das Wetter usw. anzeigen. Zusätzlich ist es denkbar, mit dem Anzeigebildschirm die Betriebszeit oder die verbleibende Betriebszeit des Haushaltsgeräts anzuzeigen.

Damit ist ersichtlich, dass die Berührungstaste nicht nur den Benutzer auf die verschiedenen Tastenfunktionen und/oder die verschiedenen Zustände, die mit der Betätigung der Berührungstaste im Zusammenhang stehen, hinweist, sondern auch den Betriebszustand des mit der Berührungstaste verbundenen Haushaltsgeräts und weitere allgemeinen Informationen anzeigt. Somit kann die Tastenfunktion komplexer definiert werden als im Stand der Technik.

Der Anzeigeinhalt der Berührungstaste ist als Antwort auf die Betätigung des Benutzers veränderbar. Die Betätigung der Berührungstaste kann nicht nur als Eingabe für die Berührungstaste, sondern auch als Auslösen der anderen Funktionen oder Zustände derselben Taste dienen. Zum Beispiel kann der Anzeigeinhalt als Antwort auf die Berührungsbedienung einer Berührungstaste zwischen "Starten des Betriebs", "Aussetzen des Betriebs" und "Stopp des Betriebs" geändert werden, ähnlich wie in den Figuren 4a, 4b und 4c gezeigt ist. Dabei kann die Berührungsbedienung der Berührungstaste sowohl eine Eingabe an die Berührungstaste und somit an die Waschmaschine erzeugen, als auch eine Änderung des Anzeigeinhalts und der Funktion der Betätigungstaste auslösen. Analog zu der Situation, die in Fig. 5a und Fig. 5b dargestellt ist, kann ebenfalls der Anzeigeinhalt als Antwort auf einen Schiebevorgang der Berührungstaste zwischen "Schieben zum Entsperren" und "Schieben zum Sperren" gewechselt werden. Dabei kann die Berührungsbedienung der Berührungstaste sowohl eine Eingabe zum Sperren oder Entsperren an die Berührungstaste und somit an die Waschmaschine erzeugen, als auch eine Änderung des Anzeigeinhalts und der Funktion der Betätigungstaste auslösen. Dadurch wird die Informationsverfolgung als Antwort auf die Betätigung der Berührungstaste ermöglicht.

Darüber hinaus ist der Anzeigeinhalt der Berührungstaste auch als Reaktion auf eine Zustandsänderung des Haushaltsgeräts veränderbar. Beispielsweise kann im Betrieb der Waschmaschine der Anzeigeinhalt als Antwort darauf geändert werden, dass die Waschmaschine in verschiedene Phasen des Programms eintritt, wobei z.B. die Berührungstaste im Betrieb nacheinander "Waschen", "Spülen" und "Entwässern" anzeigen kann. Dadurch wird die Informationsverfolgung als Reaktion auf die Zustandsänderung des Haushaltsgeräts ermöglicht.

Die vorliegende Erfindung ist nicht auf die gezeigten Ausführungsformen beschränkt, sondern umfasst alle technischen Äquivalente, die in dem Umfang der beigefügten Ansprüche stehen. Die in der Beschreibung gewählten Positionsangaben, z.B. oben, unten, links, rechts und dergleichen, beziehen sich auf die direkt beschriebenen und dargestellten Figuren und können im Sinne einer Positionsänderung an neue Orte übertragen werden.

## Patentansprüche

1. Berührungstaste (1, 2, 3) mit einem Anzeigebildschirm (12, 22, 32), die ein Bedienfeld (11, 21, 31), einen Berührungssensor (13, 23, 33), einen Anzeigebildschirm (12, 22, 32) und eine Leiterplatte (14, 24, 34) aufweist, wobei der Berührungssensor eine Berührungsbetätigung auf dem Bedienfeld erfassen kann, wobei der Berührungssensor (13, 23, 33) und der Anzeigebildschirm (12, 22, 32) jeweils mit der Leiterplatte (14, 24, 34) elektrisch verbunden sind, und wobei der Anzeigebildschirm (12, 22, 23) verschiedene Tastenfunktionen und/oder verschiedene Zustände anzeigen kann, die mit einer Betätigung der Berührungstaste im Zusammenhang stehen.

2. Berührungstaste (1, 2, 3) nach Anspruch 1, **dadurch gekennzeichnet, dass** der Berührungssensor (33) als eine Metallfolienschicht, insbesondere eine Kupferfolienschicht, auf der Leiterplatte ausgebildet ist.

3. Berührungstaste (1, 2, 3) nach Anspruch 2, **dadurch gekennzeichnet, dass** die Leiterplatte (34) eine oder mehrere Öffnungen aufweist, in die der Anzeigebildschirm (32) eingebettet ist, wobei die Metallfolienschicht um die Öffnung der Leiterplatte (34) herum angeordnet ist.

4. Berührungstaste (1, 2, 3) nach Anspruch 1, **dadurch gekennzeichnet, dass** der Berührungssensor (13) als ein Berührungsfilm ausgebildet ist, der vollständig oder teilweise zwischen dem Bedienfeld und dem Anzeigebildschirm (12) angeordnet ist.

5. Berührungstaste (1, 2, 3) nach Anspruch 1, **dadurch gekennzeichnet, dass** der Berührungssensor (23) als eine Berührungsfeder ausgebildet ist, die um den Anzeigebildschirm (22) herum zwischen dem Bedienfeld (21) und der Leiterplatte (24) abgestützt wird.

6. Berührungstaste (1, 2, 3) nach einem der Ansprüche 1 bis 5, **dadurch gekennzeichnet, dass** der Anzeigebildschirm (12, 22, 23) als ein OLED-Anzeigebildschirm ausgebildet ist.

7. Berührungstaste (1, 2, 3) nach einem der Ansprüche 1 bis 6, **dadurch gekennzeichnet, dass** die Berührungstaste ein Gehäuse (17, 27, 37) umfasst, in dem der Berührungssensor (13, 23, 33), der Anzeigebildschirm (12, 22, 32) und die Leiterplatte (14, 24, 34) aufgenommen sind.

8. Berührungstaste (1, 2, 3) nach Anspruch 7, **dadurch gekennzeichnet, dass** ein Anzeigeinhalt des Anzeigebildschirms (12, 22, 23) als Antwort auf die Betätigung der Berührungstaste veränderbar ist.

9. Berührungstaste (1, 2, 3) nach einem der Ansprüche 1 bis 8, **dadurch gekennzeichnet, dass** der Berührungssensor (13, 23, 33) eine Berührung, ein langzeitiges Drücken, ein Doppelklicken und ein Schieben erfassen kann.

10. Berührungstaste (1, 2, 3) nach einem der Ansprüche 1 bis 9, **dadurch gekennzeichnet, dass** die Berührungstaste (1, 2, 3) als Rechteck, Quadrat, Kreis, Ellipse, Dreieck oder in einer unregelmäßigen Form ausgebildet ist.

11. Berührungstaste (1, 2, 3) nach einem der Ansprüche 1 bis 10, **dadurch gekennzeichnet, dass** die Größe der Berührungstaste einem oder mehreren Fingerabdruckteilen entspricht, und/oder, dass die Größe der Berührungstaste nicht größer als 10 cm × 3 cm, vorzugsweise nicht größer als 7 cm × 2 cm, insbesondere 5 cm × 2 cm, 3 cm × 3 cm oder 2 cm × 2 cm beträgt.

12. Haushaltsgerät, das eine Berührungstaste (1, 2, 3) nach einem der Ansprüche 1 bis 11 umfasst.

13. Haushaltsgerät nach Anspruch 12, **dadurch gekennzeichnet, dass** der Anzeigebildschirm (12, 22, 32) der Berührungstaste (1, 2, 3) den Zustand des Haushaltsgeräts anzeigen kann.

14. Haushaltsgerät nach Anspruch 12 oder 13, **dadurch gekennzeichnet, dass** ein Anzeigeinhalt der Berührungstaste (1, 2, 3) als Reaktion auf eine Betätigung eines Benutzers und/oder eine Zustandsänderung des Haushaltsgeräts veränderbar ist.
